## Europäisches Patentamt
## European Patent Office
## Office européen des brevets

(19)

(11) Veröffentlichungsnummer: **0 134 902**
**B1**

(12) **EUROPÄISCHE PATENTSCHRIFT**

(45) Veröffentlichungstag der Patentschrift:
20.07.88

(51) Int. Cl.⁴: **H 01 L 39/14**

(21) Anmeldenummer: **84105863.9**

(22) Anmeldetag: **23.05.84**

(54) Mechanisch verstärkte Supraleiter mit verbesserten Eigenschaften bei hohen Magnetfeldern und Verfahren zu deren Herstellung.

(30) Priorität: **13.08.83 DE 3329390**

(43) Veröffentlichungstag der Anmeldung:
**27.03.85 Patentblatt 85/13**

(45) Bekanntmachung des Hinweises auf die Patenterteilung:
**20.07.88 Patentblatt 88/29**

(84) Benannte Vertragsstaaten:
**CH GB IT LI NL**

(56) Entgegenhaltungen:
**FR-A-1 566 033**
**FR-A-2 132 994**
**GB-A-1 160 566**

**Die Akte enthält technische Angaben, die nach dem Eingang der Anmeldung eingereicht wurden und die nicht in dieser Patentschrift enthalten sind.**

(73) Patentinhaber: **Kernforschungszentrum Karlsruhe GmbH, Weberstrasse 5 Postfach 3640, D-7500 Karlsruhe 1 (DE)**

(72) Erfinder: **Flükiger, René, Dr., Schneidemühlstrasse 6E, D-7500 Karlsruhe (DE)**
Erfinder: **Niylas, Arman, Dr., Margaritenweg 1, D-7513 Stutensee- 4 (DE)**
Erfinder: **Drost, Ernst, Bärenweg 33, D-7500 Karlsruhe 31 (DE)**
Erfinder: **Turowski, Peter, Dr., Stuttgarter Strasse 23, D-7514 Egg.- Leopoldshafen (DE)**
Erfinder: **Specking, Werner, Nagoldstrasse 22, D-7514 Egg.- Leopoldshafen (DE)**

LIBER, STOCKHOLM 1988

**Beschreibung**

Die Erfindung betrifft mechanisch verstärkte Supraleiter für Hochfeldmagnete, im wesentlichen enthaltend $Nb_3Sn$ oder $V_3Ga$ oder $Nb_3Al$ mit oder ohne Zulegierungen als supraleitendes Material, Kupfer oder eine Kupferzinn - oder eine Kupfergallium-oder eine Kupferberyllium-Legierung als Matrixmaterial für das supraleitende Material und ein Material mit einem größeren linearen thermischen Ausdehnungskoeffizienten $\alpha$ als dem des supraleitenden Materials als eine erste mechanische Verstärkung für das in das Matrixmaterial eingebettete supraleitende Material, sowie ein Verfahren zur Herstellung solcher Supraleiter, bei welchem das supraleitende Material in dem Matrixmaterial gemeinsam mit dem Material für die erste mechanische Verstärkung mit einem größeren linearen thermischen Ausdehnungskoeffizienten $\alpha$ als dem des supraleitenden Materials zu einem Verbundleiter zusammengeschlossen und danach Weiterverarbeitet wird.

Ein solcher Supraleiter und ein solches Verfahren mit $Nb_3Sn$ als supraleitendes Material und Cu als Matrixmaterial sind aus der GB-A-1 160 566 bekannt.

Die heute gebräuchlichsten supraleitenden Materialien, sind $Nb_3Sn$, $V_3Ga$ und $Nb_3Al$ für Magnete mit Feldern > 12 T. Die kritische Stromdichte $I_c$ von Vielkernsupraleitern aus $Nb_3Sn$, $V_3Ga$ oder $Nb_3Al$ zeigt dabei, vor allem $Nb_3Sn$, eine ausgeprägte Abhängigkeit vom mechanischen Spannungszustand.

Dieser Spannunggszustand kommt dadurch zustand, daß die $Nb_3Sn$- (oder $V_3Ga$-) Filamente von ~ 1- 5 µm Durchmesser entweder von Cu-Sn- (oder Cu-Ga-) Bronze oder von Kupfer umgeben sind. Dadurch, daß sowohl Cu als auch die Cu-Sn- oder Cu-Ga-Bronzen einen bedeutend größeren linearen thermischen Ausdehnungskoeffizienten ($\alpha \geqslant 16 \times 10^{-6}K^{-1}$) als $Nb_3Sn$ oder $V_3Ga$ ($\alpha \approx 7,5 \times 10^{-6}K^{-1}$) aufweisen, gleichzeitig aber im elastischen Bereich einen größeren Elastizitätsmodul besitzen, kommen durch das Abkühlen von ca. 1000 K (der Reaktionstemperatur, bei der die A15 Phase ($Nb_3Sn$ oder $V_3Ga$-Phase) gebildet wird auf 4,2 K Betriebstemperatur die $Nb_3Sn$- (oder $V_3Ga$-) Filamente unter mechanischer Kompression zu stehen. Der mechanische Zustand der Filamente wird durch einen Spannungstensor (dreiachsiger Spannungszustand) beschrieben, wobei die Komponente zur Draht-Achse ("axiale Kompression" genannt), dominiert. In der Praxis wird an Vielkernsupraleiterdrähten von 0,2 bis ca. 1 mm Durchmesser die Kompression bestimmt, indem die kritische Stromdichte $I_c$ als Funktion der axialen Dehnung, die durch Anlegen einer äußeren Spannung in Achsenrichtung erzeugt wird, aufgetragen wird. Dabei wird durch die allmähliche Kompensation der Kompression (als Folge der äußeren angelegten Spannung) ein Anstieg von $I_c$ bis zu einem Maximum, $I_{cm}$, festgestellt. Der dazu gehörige Dehnungswert, $\varepsilon_m$ (auch Prestress genannt) ist charakteristisch für die jeweilige Herstellungsmethode und die individuelle Leiterkonfiguration. Dieser Prestress, $\varepsilon_m$, beträgt nach eigenen Messungen für verschiedene $Nb_3Sn$-Leiter von ~0,1 bis ~1 %. Die niedrigsten Werte von $\varepsilon_m$ wurden für Drähte, die nach der ECN Methode hergestellt wurden (und Cu statt Cu-Sn-Bronze enthielten) gemessen ~0,1 bis 0,2 %. Für $Nb_3Sn$ oder $V_3Ga$-Leiter mit Filamenten mit $\geqslant 1$ µm Durchmesser, die nach der Bronze-Methode, der externen Diffusion oder der "Extended Mesh" Methode hergestellt wurden, beträgt $\varepsilon_m$ von 0,2 bis 0,5 %. Am größten ist $\varepsilon_m$ und damit der Kompressionszustand in Drähten, die Filamente mit Durchmesser wesentlich < 1 µm aufweisen: dort beträgr $\varepsilon_m$ 0,5 bis ~0,8 %. (Solche Drähte werden durch die "In Situ"-Methode, die pulvermetallurgische Metode oder Cu-Matrix-Methode oder bei besonderen Anwendung der Extended-Mesh-Methode hergestellt.)

Wichtig ist dabei, um wieviel die kritische Stromdichte ohne externe Spannung, $I_{co}$, vom entsprechenden maximalen Wert bei $\varepsilon_m$, $I_{cm}$, abweicht. Der Quotient $I_{cm}/I_{co}$ ist eine Funktion von $B^*_{c2}$, dem oberen kritischen Magnetfeld bei 4,2 K, und nimmt ab B = 10 T spürbar mit B zu, wobei die Zunahme für die höchsten Werte von $\varepsilon_m$ am höchsten ist. Bei 12 T kann der Quotient zwischen 1,1 und 1,5 betragen.

Im Zusammenhang mit der Entwicklung von Hochfeldspulen größeren Durchmessers, insbesondere von Fusionsspulen, haben die beim Betrieb auftretenden starken Lorentzkräfte eine mechanische Verstärkung notwendig gemacht. Der Zweck dieser Verstärkung ist es, bei den im hohen Feldbereich auftretenden Kräften die Dehnung der $Nb_3Sn$-(oder $V_3Ga$-) Filamente zu begrenzen, um letztere vor Abriß zu bewahren. Dabei gilt als größte theoretisch noch mögliche Dehnung bei Vollast $\varepsilon^T = \varepsilon_m$, in Wirklichkeit sollte aber $\varepsilon^T < \varepsilon_m$ sein, um eine gewisse Reserve zu garantieren. Die Dehnung, die bei Vollast am Leiter wirkt, setzt sich zusammen aus zwei Anteilen:

a) die Dehnung, die beim Wickelprozeß durch Biegung zustandekommt und
b) die durch die Lorentzkraft auftretende Dehnung.

Beim ersten Anteil verformt sich die Bronze und das Verstärkungsmaterial plastisch, beim zweiten sollten sie sich nur elastisch verformen, also bei den gängigen Verstärkungsmaterialien Stahl, Inconel, um die Größenordnung ~0,2 %.

Im Gegensatz zum Verhalten $I_c$ vs. $\varepsilon$ beim Einzeldraht, das in der Literatur wiederholt beschrieben wurde, wurde diese Abhängigkeit bei verstärkten Leitern erst vereinzelt untersucht. Bei allen diesen Arbeiten handelte es sich um eine Verstärkung durch austenitischen Stahl (DIN 1.4429), die z. B. als Einzeldraht vor der Reaktions-Glühung unter Zugabe von Kupfer in den Leiter eingebaut wurde, und die als "innere Verstärkung" bezeichnet wurde. Gegenüber der zweiten Verstärkungsmöglichkeit, nämlich den Stahl nach der Reaktions-Glühung durch Löten einzubauen, hat die innere Verstärkung folgende Vorteile:

1) Die Verstärkung wird in einem einzigen Arbeitsgang vor dem Glühen angebracht.
2) Kein Einlöten nötig; die Kraftübertragung geschieht ausschließlich durch Reibung.
3) Nach dem Reaktions-Glühen wirkt die Verstärkung als Sicherheitsreserve während der weiteren mechanischen Bearbeitung (Wickeln, usw.).

Allerdings steht diesen Vorteilen ein beträchtlicher Nachteil gegenüber:

Nach der die Herstellung eines Vielkernsupraleiters mit einer inneren Verstärkung, beispielsweise aus Stahl oder Inconel (80 % Ni, 14 % Cr, 6 % Ti), abschließenden Reaktions-Glühung bei beispielsweise ca. 973 K oder darüber entsteht beim Abkühlen von 973 K auf 4,2 K in Leiter außer der durch die Matrix (z. B. Bronze-Matrix), in der die supraleitenden Filamente eingebettet sind, hervorgerufene Kompression eine zusätzliche Prekompression, die auf das Verstärkungsmaterial zurückzuführen ist. Stahl bzw. Inconel kontrahieren beim Abkühlen viel stärker als beispielsweise $Nb_3Sn$:

$$\alpha_{Stahl} \approx 16 \times 10^{-6} K^{-1}$$

$$\alpha_{Inconel} \approx 14 \times 10^{-6} K^{-1}$$

Dazu sind die Elastizitätsmoduli von Stahl (E = 200 GPa) und von Inconel (E = 220 GPa) wesentlich größer als für $Nb_3Sn$ (E = 100 GPa)

Durch die unterschiedliche Kontraktion wird die dem maximalen Wert der kritischen Stromdichte $I_{cm}$ zugehörige mechanische Dehnung $\varepsilon_m$ zu höheren Werten hin verschoben, beispielsweise um bis 0,7 oder 0,8 %, insbesondere bei S.L.-Drähten mit supraleitenden Filamenten mit Durchmessern von wesentlich < 1 μm. Durch diese Verschiebung von $\varepsilon_m$, beispielsweise von 0,3 % auf ca. 1 %, wenn als Verstärkungsmaterial Stahl verwendet wird, werden jedoch die Werte für die kritische Stromdichte $I_c$ stark abgesenkt, beispielsweise un den Faktor 2,5 bei einer Magnetfeldstärke von 10 T und um den Faktor 10 bei 14 T.

Der Erfindung liegt die Aufgabe zugrunde, Vielkern-Supraleiter der genannten Art mit einer hinreichenden inneren Verstärkung bereitzustellen, welche auch zur Herstellung von Hochfeldmagneten brauchbar sind und eine verhältnismäßig hohe kritische Stromdichte gewährleisten und eine verhältnismäßig geringe Prekompression aufweisen. Es ist weiterhin Aufgabe der Erfindung, ein Verfahren zur Herstellung solcher Wielkernsupraleiter zu schaffen.

Die Aufgabe wird bei dem eingangs angegebenen Supraleiter erfindungsgemäß gelöst durch die Kombination

a) des supraleitenden Materials im Matrixmaterial und

b) der ersten mechanischen Verstärkung mit

c) einer zuzätzlichen mechanischen Verstärkung aus einem Material mit einem kleineren linearen thermischen Ausdehnungskoeffizienten $\alpha$ als dem des supraleitenden Materials, die die thermische Kontraktionswirkung der ersten Verstärkung auf das supraleitende Material zumindest teilweise kompensiert.

Eine vorteilhafte Ausbildung der Erfindung ist gekennzeichnet durch mindestens ein erstes Verstärkungselement aus Stahl und/oder Inconel in Kombination mit mindestens einem zuzätzlichen Verstärkungselement aus Molybdän.

Eine Weitere Ausbildung der Erfindung ist gegeben durch mindestens ein erstes Verstärkungselement aus einer (oder mehreren) Legierung(en) aus der Gruppe Ti-V-Al, Cu-Zr, Cu-Si, $Cu-Al_2O_3$ oder Cu-Be, wobei Cu-Be nur benutzt wird, im Falle der Verwendung von Kupfer oder Cu-Sn oder Cu-Ga als Matrixmaterial, in Kombination mit mindestens einem zusätlichen Verstärkkungselement aus Molybdän.

Weitere alternative Ausbildungen der Erfindung sind gekenzeichnet:

1. durch mindestens ein erstes Verstärkungselement aus Stahl und/oder Inconel in Kombination mit mindestens einem zusätzlichen Verstärkungselement aus einem (oder mehreren) Metall(en) aus der Gruppe Hf, Nb, Ta, W, Re oder der Legierung 0,5 Gew.-% Ti; 0,07 Gew.-% Zr; 0,05 Gew.-% C; Rest Mo (TZM) und

2. durch mindestens ein Verstärkungselement aus einer (oder mehreren) Legierung(en) aus der Gruppe Ti-V-Al, Cu-Zr, Cu-Si, $Cu-Al_2O_3$ oder Cu-Be, wobei Cu-Be nur benutzt wird im Falle der Verwendung von Kupfer oder Cu-Sn oder Cu-Ga als Matrixmaterial, in Kombination mit mindestens einem zusätzlichen Verstärkungselement aus einem (oder mehreren) Metall(en) aus der Gruppe Hf, Nb, Ta, W, Re oder der Legierung 0,5 Gew.-% Ti; 0,07 Gew.-% Zr; 0,05 Gew.-% C; Rest Mo (TZM).

Die alternativ erwähnten Zulegierungen zum supraleitenden Material, wie sie in der Veröffentlichung der Europäischen Patentanmeldung EP-A-0 048 313 offenbart sind, verringern zwar den Prestress-Effekt, der durch die Matrix (z. B. Bronze-Matrix) auf die supraleitenden Filamente erzeugt wird, sind jedoch nicht in der Lage, die Prekompression, hervorgerufen durch die innere Verstärkung, in gewünschtem Ausmaße zu reduzieren. Erst die erfindungsgemäße Kombination mit dem zusätzlichen Verstärkungsmaterial mit einem kleineren linearen thermischen Ausdehnungskoeffizienten $\alpha$ als dem des supraleitenden Materials ist zumindest eine teilweise Kompensation der negativen Auswirkung des Verstärkungsmaterials Stahl oder Inconel auf das supraleitende Material zu erreichen. Durch die kombinierte Wirkung des Verstärkungsmaterials mit einem größerem $\alpha$ und des Verstärkungsmaterials mit einem kleineren $\alpha$ als dem des supraleitenden Materials wird der resultierende $\alpha$-Wert bzw. die Kontraktion dem bzw. der des supraleitenden Materials sehr ähnlich.

In der nachfolgenden Tabelle sind beispielhaft für einige Materialien mit kleinerem $\alpha$ als dem von $Nb_3Sn$ und die entsprechenden Elastizitäts-Moduli aufgeführt:

| Beispiel: | zusätzliches Verstärkungs- material | α[x10⁻⁶K⁻¹] | E-Modul (GPa) |
|---|---|---|---|
| 1 | Mo | 5.4 | 320 |
| 2 | TZM (0,5 % Ti; 0,07 % Zr; 0,05 % C, Rest Mo) | 5.4 | 320 |
| 3 | W | 4.5 | 400 |
| 4 | Ta | 5 | 190 |

Das Verfahren zur Herstellung eines mechanisch verstärkten Supraleiters gemäß Anspruch 1 ist ausgehend von dem eingangs genannten Verfahren gemäß der Erfindung dadurch gekennzeichnet, daß in den Verbundleuter zusätzlich das Material für die zusätzliche mechanische Verstärkung mit einem kleineren linearen thermischen Ausdehnungskoeffizienten α als dem des supraleitenden Materials eingebracht wird, so daß die thermische Kontraktionswirkung der ersten mechanischen Verstärkung auf das supraleitenden Material zumindest teilweise kompensiert wird.

Als Verstärkungsmaterial mit kleinerem α kann Molybdän verwendet werden. Es ist jedoch ebenso vorteilhaft, wenn als Verstärkungsmaterial mit kleinerem α mindestens eine Species aus der Gruppe Hf, Nb, Ta, W, Re, TZM (0,5 Gew.-% Ti; 0,07 Gew.-% Zr; 0,05 Gew.-% C; Rest Mo) verwendet wird. Es kann aber auch als Verstärkungsmaterial mit kleinerem α mindestens ein Verstärkkungselement aus Mo und mindestens ein Verstärkungselemente aus einem bzw. mehreren Materialien aus der Gruppe Hf, Nb, Ta, W, Re, TZM verwendet werden. Eine vorteilhafte Ausbildung der Erfindung ist dadurch gekennzeichnet, daß als Verstärkungsmaterial mit größerem α mindestens eine Species aus der Gruppe Ti-V-Al, Cu-Zr, Cu-Si, Cu-Al₂O₃ oder Cu-Be verwendet wird, wobei Cu-Be nur benutzt wird im Falle der Verwendung von Kupfer oder Cu-Sn oder Cu-Ga als Matrixmaterial, und daß als Verstärkungsmaterial mit kleinerem α Molybdän verwendet wird.

Alternativ kann folgende Zusammenstellung verwendet werden:

Als Verstärkungsmaterial mit größerem α mindestens eine Species aus der Gruppe Ti-V-Al, Cu-Zr, Cu-Si, Cu-Al₂O₃ oder Cu-Be, wobei Cu-Be nur benutzt wird im Falle der Verwendung von Kupfer oder Cu-Sn oder Cu-Ga als Matrixmaterial und als Verstärkungsmaterial mit kleinerem α mindestens eine Species aus der Gruppe Hf, Nb, Ta, W, Re, TZM.

Eine andere alternative Ausführungsart der Erfindung ist dadurch gekennzeichnet, daß als Verstärkungsmaterial mit größerem α mindestens ein Verstärkungselement aus Stahl oder Inconel und/oder mindestens ein Verstärkungselement aus einem bzw. mehreren Materialien aus der Gruppe Ti-V-Al, Cu-Zr, Cu-Si, Cu-Al₂O₃, Cu-Be und als Verstärkungsmaterial mit kleinerem α mindestens ein Verstärkungselement aus einem bzw. mehreren Materialien aus der Gruppe Hf, Nb, Ta, W, Re, TZM verwendet werden.

Gemäß einer weiteren besonderen Ausführungsart der Erfindung werden die Verstärkungsmaterialien, die mit dem supraleitenden Material und der dieses umgebenden Matrix zu einem Verbund zusammengeschlossen werden, in einer Menge in den Supraleiter eingebracht, die einem Verhältnis der Summe der Querschnittsflächen der Vertärkungsmaterialien zur Gesamtquerschnittsfläche des Supraleiters im Bereich zwischen 1 % und 50 % entspricht. Die Verstärkungsmaterialien werden vorteilhafterweise in einer Menge in den Verbundleiter eingebracht, die einem Verhältnis der Querschnittssumme der Materialien mit größerem α zu der Querschnittssumme der Materialien mit kleinerem α im Bereich von 1 zu 5 bis 5 zu 1 entspricht. Entweder wird das Material mit kleinerem α in einem zumindest gleichgroßen Abstand oder kleinerem Abstand von der Zentrallinie des Verbundleiters wie bzw. als der Abstand des Materials mit dem größeren α in den Verbundleiter eingebracht oder das Material mit kleinerm α in einem zumindest gleichgroßen oder kleinerem Abstand wie bzw. als der Abstand des Materials mit dem größeren α von einer exzentrisch im Verbundleiter gedachten Linie in diesen eingebracht. Das Verstärkungsmaterial kann in Form von einem oder mehreren Verbund-Verstärkungs-Elementen, jeweils innen aus Material mit kleinerem α und außen aus Material mit größerem α bestehend, in den Leiter eingebracht werden. Die beiden in ihren thermischen Ausdehnungseigenschaften einander entgegenwirkenden Verstärkungsmaterialien können entweder als solche oder die aus diesen bestehenden Verbund-Verstärkungselemente symmetrisch zum supraleitenden Material in den Verbundleiter eingebracht werden.

Beide in ihrer Ausdehnungseigenschaft einander entgegenwirkenden Arten der Verstärkungsmaterialien können jeweils als Draht, Rohr, Band oder Profil für sich allein in den Supraleiter eingebaut werden oder als Verbund-Verstärkungs-Elemente, wobei diese so zusammengesetzt sind, daß sich im Verbund das Material mit dem kleineren α innen und das Material mit dem größerem α außen befindet. Drahtförmige Verstärkungen können auch als Netze ausgebildet sein. Ist das draht- oder band-förmige Verstärkungsmarerial mit dem größeren α in einer bestimmten Richtung im Supraleiter vertwistet, so muß das entsprechende Material mit dem kleineren α in Gegenrichtung vertwistet sein.

4

Ein besonderer Vorteil der erfindungsgemäßen Supraleiter ist darin zu sehen, daß je nach den bei der Herstellung einer Hochfeldspule größeren Durchmessers sich ergebenden Bedingungen ein vorbestimmtes Maß an Prekompresion im Supraleiter eingestellt werden kann, ausschließlich durch Ermittlung jeweils ausgesuchter Verhältnisse der Querschnittssumme eines bestimmten Verstärkungsmaterials mit größerem $\alpha$ zu der Querschnittssumme eines bestimmten ausgewählten Verstärkungsmaterials mit einem kleineren $\alpha$, ggf. in Verbindung mit einem vorbestimmten Grad an Symmetrie der einander entgegenwirkenden Materialien. Es somit praktisch jeder gewünschte Wert für die Prekompression einstellbar.

Zur weiteren Erläuterung der Erfindung werden nachfolgend einige beispielhafte Ausführungen für Verbund-Verstärkungs-Elemente und für die wesentlichen Bestandteile der erfindungsgemäßen Supraleiter in Verbindung mit den Figuren erläutert.

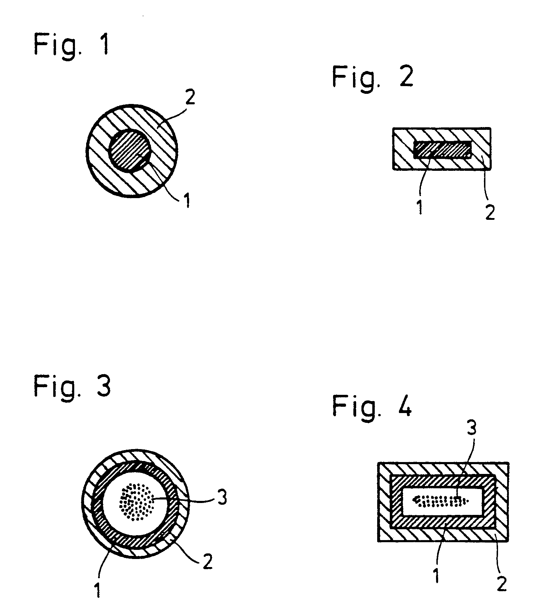

Die Figuren 1 und 2 zeigen in schematischer Weise jeweils Querschnitte von Verbund-Verstärkungs-Elementen mit einem Material 1 mit kleinerem $\alpha$ (beispielsweise aus Molybdän) und einem Material 2 mit größerem $\alpha$ (beispielsweise aus Stahl). Der Querschnitt in Figur 1 entspricht dem eines Drahtes, der Querschnitt in Figur 2 dem eines Bandes. Die in Figur 1 und Figur 2 in Form ihres Querschnitts dargestellten Verstärkungselemente können, unter Berücksichtigung einer symmetrischen Verteilung nahezu beliebig im Supraleiter angeordnet sein.

Die Figuren 3 und 4 zeigen ebenfalls in schematischer Weise jeweils einen Querschnitt eines Supraleiterkerns mit einem Supraleiterdraht 3 aus einer Vielzahl von Supraleiterfilamenten in einer Matrix (beispielsweise $Nb_3Sn$-Filamenten in einer Bronze-Matrix) zunächst umschlossen von einem Rohr aus Verstärkungsmaterial 1 mit kleinerem $\alpha$ und umgeben von einem Außenrohr aus einem Verstärkungsmaterial 2 mit größerem $\alpha$ als dem des Materials der supraleitenden Filamente. Auch in dieser Anordnung kann das Material 1 aus Molybdän, das Material 2 aus Stahl bestehen. Figur 4 zeigt einen bandförmigen Supraleiterkern bzw. Supraleiter ohne Änderung des Aufbau-Prinzips gegenüber dem Supraleiterkern gemäß Fig. 3.

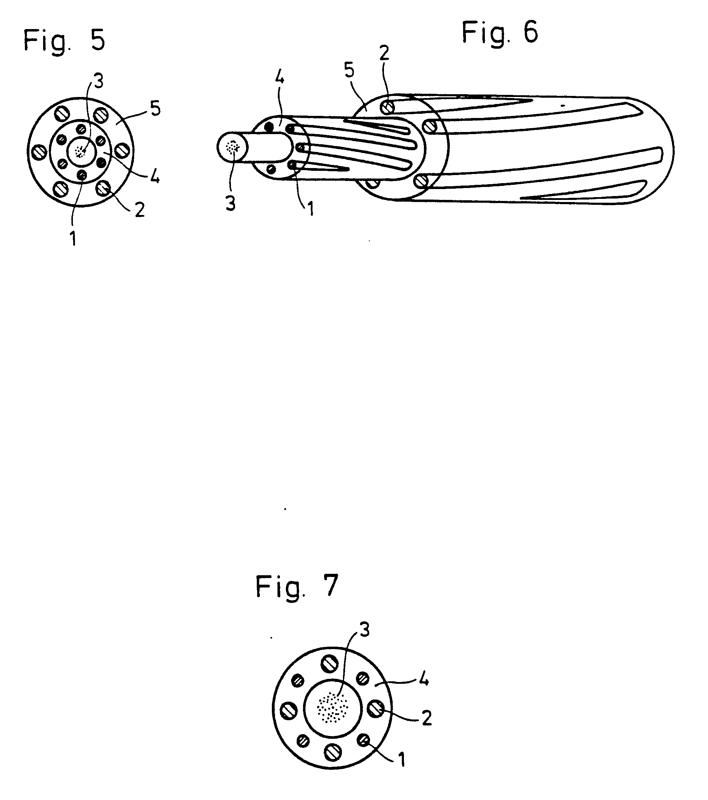

Figur 5 zeigt einen weiteren möglichen Querschnitt eines Supraleiterdrahtes mit innerer Verstärkung, bestehend aus einem zentralen supraleitenden Teil 3 aus einer Vielzahl von supraleitenden Filamenten in einer Matrix, zunächst umgeben von 6 Drähten 1 aus beispielsweise TZM in einer bekannten Stabilisierungsschich 4 (beispielsweise Kupfer etc.) in symmetrischer Anordnung, welche letztlich umschlossen sind von 6 Drähten 2 aus beispielsweise Inconel in einer ebenfalls bekannten Stabilisierungsschicht 5 beispielsweise aus Aluminium, ebenfalls die Symmetrie einhaltend. Die Drähte 1 und 2 können auch als Netze ausgebildet sein.

Figur 6 zeigt schematisch aus seitlicher Sicht den möglichen Aufbau eines Supraleiterdrahtes mit gleichem Querschnitt wie in Figur 5 mit der Ausnahme, daß die Drähte 1 und 2 (bzw. Netze 1 und 2) im Gegensinn vertwistet sind.

Figur 7 zeigt schematisch einen Querschnitt eines Supraleiters, bei welchem die Verstärkungsmaterialien 1 und 2 (beispielsweise Wolfram und Ti-V-Al) in abwechselnder Reihenfolge um beispielsweise $V_3Ga$-Filamente 3 in einer Cu-Ga-Matrix angeordnet sind und in einem bekannten Stabilisierungsmaterial 4 (z. B. aus Kupfer) eingebettet liegen.

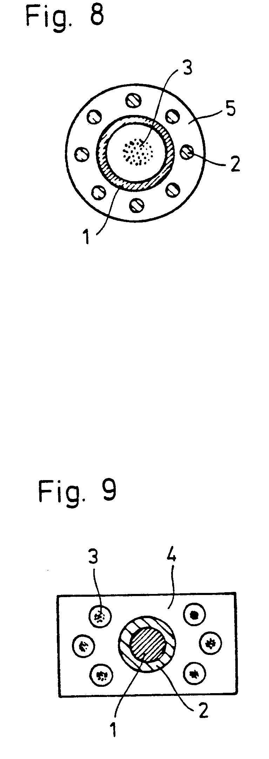

Figur 8 stellt in schematischer Weise einen Supraleiterdraht dar, bei welchem eine Vielzahl von Filamenten 3 aus beispielsweise $Nb_3Al$ in einer Kupfermatrix von einem Rohr aus Verstärkungsmaterial 1 (beispielsweise aus Tantal) umschlossen ist, um welches wiederum eine Schicht aus einem bekannten Stabilisierungsmaterial 5, beispielsweise aus Aluminium, mit 8 eingebetteten Drähten 2 (z. B. aus $Cu-Al_2O_3$) angeordnet ist.

Figur 9 ist eine schematische Darstellung des Querschnittes eines Supraleiters, in dessen Mitte sich ein Verbund-Verstärkungs-Element in Form eines Drahtes mit einem Kern aus Material 1 (z. B. Molybdän) und mit einer äußeren Schicht aus Material 2 (z. B. Stahl) befindet. Um dieses Verbund-Verstärkungs-Elemente herum sind 6 Supraleiterdrähte 3 (z. B. aus einer Vielzahl von $Nb_3Sn$-Filamenten in Bronze-Matrix) in einem Stabilisierungsmaterial 4 (z. B. aus Aluminium) angeordnet.

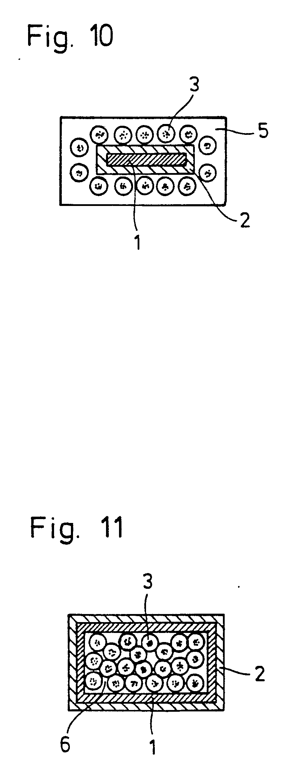

Figur 10 zeigt in schematischer Weise einen Querschnitt eines Supraleiters, der ähnlich aufgebaut ist wie der in Figur 9. In dieser Darstellung hat das Verbund-Vetärkungs-Element die Form eines Bandes, um welches sich eine größere Anzahl Supraleiterdrähte 3, eingebettet in ein der thermischen und elektrischen Stabilisierung dienendes Material 5 (aus beispielsweise Kupfer), scharen.

Figur 11 stellt schematisch einen Querschnitt eines Supraleiters dar, der eine Vielzahl von Supraleiterdrähten 3 enthält mit Zwischenräumen 6, durch welche flüssiges Helium von ca. 4 K hindurchströmen kann, mit einem als Hülle ausgebildeten Verbund-Verstärkungs-Element aus einer inneren Schicht aus Material 1 und einer äußeren Schicht aus Material 2. Die Supraleiterdrähte können hierbei aus einer Vielzahl von $Nb_3Sn$-Filamenten in einer Cu-Sn-Matrix bestehen, das Verbund-Verstärkungs-Element innen aus Molybdän und außen aus Inconel.

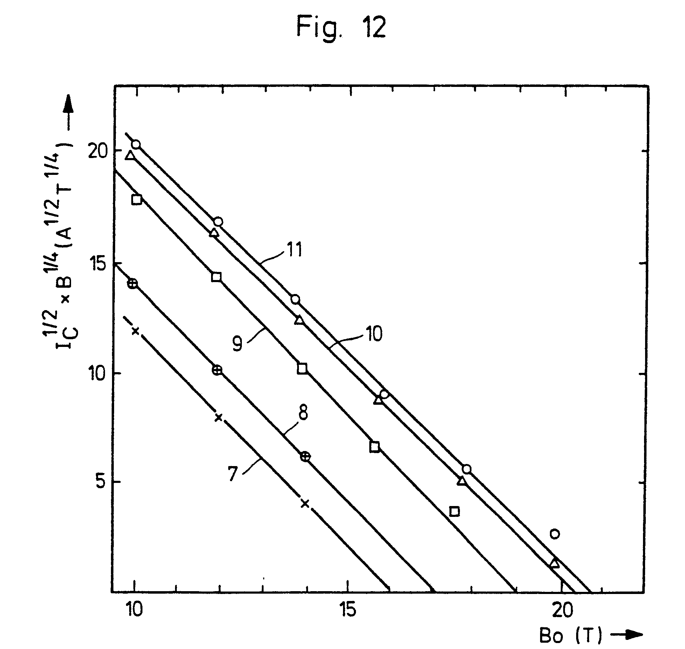

Figur 12 ist eine graphische Darstellung, deren Kurven 7 bis 11 die Wirkung erfindungsgemäßer Supraleiter in hohen kritischen Magnetfeldern aufzeigt im Vergleich zu zum Stande der Technik gehörigen Supraleitern, die ausschließlich mit Stahl verstärkt worden sind. Für alle Untersuchungen, deren Ergebnisse in diesem Diagramm eingetragen worden sind, wurden $Nb_3Sn$-Bronze-Drähte mit einem Durchmesser von 0,62 mm und mit einer internen Verstärkung verwendet, welche 64 Stunden lang einer abschließenden Wärmebehandlung bei 973° K unterzogen worden sind.

Kurve 7: Draht mit 14,5 % des Gesamtquerschnitts aus Stahl.

Kurve 8: Draht mit 6,5 % des Gesamtquerschnitts auf Stahl.

Kurve 9: Draht mit 6,5 % Stahl und 2,5 % Molybdän, bezogen auf den Gesamtquerschnitt.

Kurve 10: Draht mit 2,1 % Stahl und 2,5 % Molybdän, bezogen auf den Gesamtquerschnitt.

Kurve 11: Draht mit 2,1 % Stahl und 5,0 % Molybdän, bezogen auf den Gesamtquerschnitt.

Es wird deutlich, daß die zum Stande der Technik gehörigen Supraleiterdrähte, die nur mit Stahl verstärkt worden sind, nur kritische Feldstärkewerte von 16 bzw. 17 erreichen, während die erfindungsgemäß verstärkten Supraleiterdrähte wesentlich höhere Werte erreichen können.

**Patentansprüche**

1. Mechanisch verstärkte Supraleiter für Hochfeldmagnete, im wesentlichen enthaltend $Nb_3Sn$ oder $V_3Ga$ oder $Nb_3Al$ mit oder ohne Zulegierungen als supraleitendes Material, Kupfer oder eine Kupfer-Zinn- oder eine Kupfer-Gallium-oder eine Kupfer-Beryllium-Legierung als Matrixmaterial für das supraleitende Material und ein Material mit einem größeren linearen thermischen Ausdehnungskoeffizienten $\alpha$ als dem des supraleitenden Materials als erste mechanische Verstärkung für das in das Matrixmaterial eingebettete supraleitende Material gekennzeichnet durch

die Kombination
a) des supraleitenden Materials in dem Matrixmaterial und
b) der ersten mechanischen Verstärkung mit
c) einer zusätzlichen mechanischen Verstärkung aus einem Material mit einem kleineren linearen thermischen Ausdehnungskoeffizienten $\alpha$ als dem des supraleitenden Materials, die die thermische Kontraktionswirkung der ersten Verstärkung auf das supraleitende Material zumindest teilweise kompensiert.

2. Mechanisch verstärkter Supraleiter gemäß Anspruch 1, gekennzeichnet durch mindestens ein erstes Verstärkungselement aus Stahl und/oder Inconel in Kombination mit mindestens einem zusätzlichen Verstärkungselement aus Molybdän.

3. Mechanisch verstärkter Supraleiter gemäß Anspruch 1, gekennzeichnet durch mindestens ein erstes Verstärkungselement aus einer (oder mehreren) Legierung(en) aus der Gruppe Ti-V-Al, Cu-Zr, Cu-Si, $Cu-Al_2O_3$ oder Cu-Be, wobei Cu-Be nur benutzt wird im Falle der Verwendung von Kupfer oder Cu-Sn oder Cu-Ga als Matrixmaterial, in Kombination mit mindestens einem zusätzlichen Verstärkungselement aus Molybdän.

4. Mechanisch verstärkter Supraleiter gemäß Anspruch 1, gekennzeichnet durch mindestens ein erstes Verstärkungselement aus Stahl und/oder Inconel in Kombination mit mindestens einem zusätzlichen Verstärkungselement aus einem (oder mehreren) Metall(en) aus der Gruppe Hf, Nb, Ta, W, Re oder der Legierung 0,5 Gew.-% Ti; 0,07 Gew.-% Zr; 0,05 Gew.-% C; Rest Mo (TZM).

5. Mechanisch verstärkter Supraleiter gemäß Anspruch 1, gekennzeichnet durch mindestens ein erstes Verstärkungselement aus einer (oder mehreren) Legierung(en) aus der Gruppe Ti-V-Al, Cu-Zr, Cu-Si, $Cu-Al_2O_3$ oder Cu-Be, wobei Cu-Be nur benutzt wird im Falle der Verwendung von Kupfer oder Cu-Sn oder Cu-Ga als Matrixmaterial in Kombination mit mindestens einem zusätzlichen Verstärkungselement aus einem (oder mehreren) Metall(en) aus der Gruppe Hf, Nb, Ta, W, Re oder der Legierung 0,5 Gew.-% Ti; 0,07 Gew.-% Zr ; 0,05 Gew.- % C; Rest Mo (TZM).

6. Verfahren zur Herstellung eines mechanisch verstärkten Supraleiters gemäß Anspruch 1, bei welchem das supraleitende Material in dem Matrixmaterial gemeisam mit dem Material für die erste mechanische Verstärkung mit einem größeren linearen thermichen Ausdehnungskoeffizienten $\alpha$ als dem des supraleitenden Materials zu einem Verbundleiter zusammengeschlossen und danach weiterverarbeitet wird, dadurch gekennzeichnet. daß in dem Verbundleiter zusätzlich das Material für die zusätzliche mechanische Verstärkung mit einem kleineren linearen thermischen Ausdehnungskoeffizieten $\alpha$ als dem des supraleitenden Materials eingebracht wird, so daß die thermische Kontraktionswirkung der ersten mechanischen Verstärkung auf das supraleitende Material zumindest teilweise kompensiert wird.

7. Verfahren nach Anspruch 6, dadurch gekennzeichnet, daß als Verstärkungsmaterial mit kleinerem $\alpha$ Molybdän verwendet wird.

8. Verfahren nach Anspruch 6, dadurch gekennzeichnet. daß als Verstärkungsmaterial mit kleinerem $\alpha$ mindestens eine Species aus der Gruppe Hf, Nb, Ta, W, Re, TZM (0,5 Gew.-% Ti; 0,07 Gew.-% Zr; 0,05 Gew.-% C; Rest Mo) verwendet wird.

9. Verfahren nach Anspruch 6, dadurch gekennzeichnet, daß als Verstärkungsmaterial mit kleinerem $\alpha$ mindestens ein Verstärkungselement aus Mo und mindestens ein Verstärkungselement aus einem bzw. mehreren Materialien aus der Gruppe Hf, Nb, Ta, W, Re, TZM verwendet werden.

10. Verfahren nach Anspruch 6, dadurch gekennzeichnet. daß als Verstärkungsmaterial mit größerem $\alpha$ mindestens eine Species aus der Gruppe Ti-V-Al, Cu-Zr, Cu-Si, $Cu-Al_2O_3$ oder Cu-Be verwendet wird, wobei Cu-Be nur benutzt wird im Falle der Verwendung von Kupfer oder Cu-Sn oder Cu-Ga als Matrixmaterial, und daß als Verstärkungsmaterial mit kleinerem $\alpha$ Molybdän verwendet wird.

11. Verfahren nach Anspruch 6, dadurch gekennzeichnet, daß als Verstärkungsmaterial mit größerem $\alpha$ mindestens eine Species aus der Gruppe Ti-V-Al, Cu-Zr, Cu-Si, $Cu-Al_2O_3$ oder Cu-Be verwendet wird, wobei Cu-Be nur benutzt wird im Falle der Verwendung von Kupfer oder Cu-Sn oder Cu-Ga als Matrixmaterial, und daß als Verstärkungsmaterial mit kleinerem $\alpha$ mindestens eine Species aus der Gruppe Hf, Nb, Ta, W, Re, TZM verwendet wird.

12. Verfahren nach Anspruch 6, dadurch gekennzeichnet, daß als Verstärkungsmaterial mit größerem $\alpha$ mindestens ein Verstärkungselement aus Stahl oder Inconel und/oder mindestens ein Verstärkungselement aus einem bzw. mehreren Materialien aus der Gruppe Ti-V-Al, Cu-Zr, Cu-Si, Cu-Al$_2$O$_3$, Cu-Be und als Verstärkungsmaterial mit kleinerem $\alpha$ mindestens ein Verstärkungselement aus einem bzw. mehreren Materialien aus der Gruppe Hf, Nb, Ta, W, Re, TZM verwendet werden.

13. Verfahren nach Anspruch 6, dadurch gekennzeichnet, daß die Verstärkungsmaterialien, die mit dem supraleitenden Material und der dieses umgebenden Matrix zu einem Verbund zusammengeschlossen werden, in einer Menge in den Supraleiter eingebracht werden, die einem Verhältnis der Summe der Querschnittsflächen der Verstärkungsmaterialien zur Gesamtquerschnittsfläche des Supraleiters im Bereich zwischen 1 % und 50 % entspricht.

14. Verfahren nach Anspruch 6, dadurch gekennzeichnet, daß die Verstärkungsmaterialien in einer Menge in den Verbundleiter eingebracht werden, die einem Verhältnis der Querschnitts-Summe der Materialein mit größerem $\alpha$ zu der Querschnitts-Summe der Materialien mit kleinerm $\alpha$ im Bereich von 1 zu 5 bis 5 zu 1 entspricht.

15. Verfahren nach Anspruch 6, dadurch gekennzeichnet, daß entweder das Material mit kleinerem $\alpha$ in einem zumindest gleich großen Abstand oder kleinerem Abstand von der Zentrallinie des Verbundleiters wie bzw. als der Abstand des Materials mit dem größeren $\alpha$ in den Verbundleiter eingebracht wird oder das Material mit kleinerem $\alpha$ in einem zumindest gleich großen oder kleinerem Abstand wie bzw. als der Abstand des Materials mit dem größeren $\alpha$ von einer exzentrisch im Verbundleiter gedachten Linie in diesen eingebracht wird.

16. Verfahren nach Anspruch 6, dadurch gekennzeichnet, daß das Verstärkungsmaterial in Form von einem oder mehreren Verbund-Verstärkungs-Elementen, jeweils innen aus Material mit kleinerem $\alpha$ und außen aus Material mit größerem $\alpha$ bestehend, in den Leiter eingebracht wird.

17. Verfahren nach einem der Ansprüche 12 bis 16, dadurch gekennzeichnet, daß entweder die beiden in ihren thermischen Ausdehnungseigenschaften einander entgegenwirkenden Verstärkungsmaterialien als solche oder die aus diesen beiden bestehenden Verbund-Verstärkungs-Elemente (Fig. 1, Fig. 2) symmetrisch zum supraleitenden Material in den Verbundleiter eingebracht werden.

## Claims

1. Mechanically strengthened superconductors for strong magnetic fields, substantially containing Nb$_3$Sn or V$_3$Ga or Nb$_3$Al with or without additional alloys as the superconductive material, copper or a coppertin or a copper-gallium or a copper-beryllium alloy as the matrix material for the superconductive material and a material having a greater linear thermal coefficient of expansion $\alpha$ than that of the superconductive material as the first mechanical strengthening for the superconductive material embedded in the matrix material, characterised by the combination

    a) of the superconductive material in the matrix material and

    b) of the first mechanical strengthening with

    c) an additional mechanical strengthening formed from a material having a smaller linear thermal coefficient of expansion $\alpha$ than that of the superconductive material, which additional mechanical strengthening at least partly compensates for the thermal contraction effect of the first strengthening on the superconductive material.

2. Mechanically strengthened superconductor according to claim 1, characterised by at least one first strengthening element formed from steel and/or inconel in combination with at least one additional strengthening element formed from molybdenum.

3. Mechanically strengthened superconductor according to claim 1, characterised by at least one first strengthening element formed from one (or more) alloy(s) from the group Ti-V-Al, Cu-Zr, Cu-Si, Cu-Al$_2$O$_3$ or Cu-Be, wherein Cu-Be is only used in the case where copper or Cu-Sn or Cu-Ga is utilised as the matrix material, in combination with at least one additional strengthening element formed from molybdenum.

4. Mechanically strengthened superconductor according to claim 1, characterised by at least one first strengthening element formed from steel and/or inconel in combination with at least one additional strengthening element formed from one (or more) metal(s) from the group Hf, Nb, Ta, W, Re or the. allot 0.5 % by wt Ti; 0.07 % by wt Zr; 0.05 % by wt C; remainder Mo (TZM).

5. Mechanically strengthened superconductor according to claim 1, characterised by at least one first strengthening element formed from one (or more) alloy(s) from the group Ti-V-Al, Cu-Zr, Cu-Si, Cu-Al$_2$O$_3$ or Cu-Be, wherein Cu-Be is only used in the case where copper or Cu-Sn or Cu-Ga is utilised as the matrix material in combination with at least one additional strengthening element formed from one (or more) metal(s) from the group Hf, Nb, Ta, W, Re or the alloy 0.5 % by wt Ti; 0.07 % by wt Zr; 0.05 % by wt C; remainder Mo (TZM).

6. Method of making a mechanically strengthened superconductor according to claim 1, wherein the superconductive material in the matrix material is combined together with the material for the first mechanical strengthening, having a greater linear thermal coefficient of expansion $\alpha$ than that of the superconductive material, to form a compound conductor and is subsequently processed further, characterised in that the material for the additional mechanical strengthening, having a smaller linear thermal coefficient of expansion $\alpha$ than that of the superconductive material, is additionally introduced in the compound conductor, so that the thermal contraction effect of the first mechanical strengthening on the superconductive material is at least partly compensated-for.

7. Method according to calim 6, characterised in that molybdenum is used as the strengthening material with a smaller $\alpha$.

8. Method according to claim 6, characterised in that at least one species from the group Hf, Nb, Ta, W, Re, TZM (0.5 % by wt Ti; 0.07 % by wt Zr; 0.05 % by wt C; remainder Mo) is used as the strengthening material with a smaller $\alpha$.

9. Method according to claim 6, characterised in that at least one strengthening element formed from Mo and at least one strengthening element formed from one or more materials from the group Hf, Nb, Ta, W, Re, TZM are used as the strengthening material with a smaller $\alpha$.

10. Method according to claim 6, characterised in that at least one species from the group Ti-V-Al, Cu-Zr, Cu-Si, Cu-Al$_2$O$_3$ or Cu-Be is used as the strengthening material with a greater $\alpha$, wherein Cu-Be is only used in the case where copper or Cu-Sn or Cu-Ga is utilised as the matrix material, and in that molybdenum is used as the strengthening material with a smaller $\alpha$.

11. Method according to claim 6, characterised in that at least one species from the group Ti-V-Al, Cu-Zr, Cu-Si, Cu-Al$_2$O$_3$ or Cu-Be is used as the strengthening material with a greater $\alpha$, wherein Cu-Be is only used in the case where copper or Cu-Sn or Cu-Ga is utilised as the matrix material, and in that at least one species from the group Hf, Nb, Ta, W, Re, TZM is used as the strengthening material with a smaller $\alpha$.

12. Method according to claim 6, characterised in that at least one strengthening element formed from steel or inconel and/or at least one strengthening element formed from one or more materials from the group Ti-V-Al, Cu-Zr, Cu-Si, Cu-Al$_2$O$_3$, Cu-Be are used as the strengthening material with a greater $\alpha$, and at least one strengthening element formed from one or more materials from the group Hf, Nb, Ta, W, Re, TZM is used as the strengthening material with a smaller $\alpha$.

13. Method according to claim 6, characterised in that the strenghening materials, which are combined with the superconductive material and the matrix surrounding this material to form a compound, are introduced into the superconductor in an amount which corresponds to a ratio of the sum of the areas of cross-section of the strengthening materials relative to the total area of cross-section of the superconduction in the rang of between 1 % and 50 %.

14. Method according to claim 6, characterised in that the strengthening materials are introduced into the compound conductor in an amount which corresponds to a ratio of the cross-sectional sum of the materials with a greater $\alpha$ relative to the crossectional sum of the materials with a smaller $\alpha$ in the range of 1 to 5 to 5 to 1.

15. Method according to claim 6, characterised in that either the material with a smaller $\alpha$ is introduced into the compound conductor at a distance from the central line of the compound conductor which is at least equal in size to or smaller than the distance of the material with the greater $\alpha$, or the material with a smaller $\alpha$ is introduced into the compound conductor at a distance from an imaginary line extending eccentrically in the compound conductor which is at least equal in size to or smaller than the distance of the material with the greater $\alpha$.

16. Method according to claim 6, characterised in that the strengthening material is introduced into the conductor in the form of one or more compound strengthening elements, each element being internally formed from material with a smaller $\alpha$ and externally formed from material with a greater $\alpha$.

17. Method according to one of claims 12 to 16, characterised in that either the two strengthening materials, which act against each other in respect of their thermal expansion properties, are introduced into the compound conductor as such, or the compound strengthening elements (Fig. 1, Fig. 2) formed from both these strengthening materials are introduced into the compound conductor symmetrically with the superconductive material.

**Revendications**

1. Supra-conducteur renforcé mécaniquement pour des champs magnétiques élévés, contenant essentiellement du Nb$_3$Sn ou du V$_3$Ga ou du Nb$_3$Al avec ou sans additions par alliage comme matériaux supraconducteurs, du cuivre ou un alliage de cuivre et d'étain ou de cuivre et de gallium ou de cuivre et de béryllium comme matériau de matrice pour le matériau supra-conducteur, et un matériau présentant un coefficient de dilatation thermique linéaire $\alpha$ supérieur à celui du matériau supra-conducteur et qui sert de premier renforcement mécanique pour le matériau supra-conducteur enrobé du matériau de matrice, caractérisé en ce qu'il combine

a) le matériau supra-conducteur dans le matériau de matrice et

b) le premier renforcement mécanique avec

c) un renforcement mécanique supplémentaire constitué d'un matériau d'un coefficient de dilatation thermique linéaire $\alpha$ inférieur à celui du matériau supra-conducteur et qui compense du moins partiellement l'effet de contraction thermique du premier renforcement sur le matériau supra-conducteur.

2. Supta-conducteur renforcé mécaniqueement selon la revendication 1, caractérisé en qu'il contient au moins un premier élément de renforcement en acier et/ou en Inconel en combinaison avec au moins un élément de renforcement supplémentarie en molybdène.

3. Supra-conducteur renforcé mécaniquement selon la revendication 1, caractérisé en ce qu'il contient au moins un premier élément de renforcement en un (ou plusieurs) alliage(s) du groupe Ti-V-Al, Cu-Zr, Cu-Si, Cu-Al$_2$O$_3$ ou Cu-Be, Cu-Be n'étant utillisé qu'en cas d'utilisation de cuivre ou de Cu-Sn ou Cu-Ga comme matériau de matrice, en combinaison avec au moins un élément de renforcement supplémentaire en molybdène.

4. Supra-conducteur renforcé mécaniquement selon la revendication 1, caractérisé en ce qu'il possède au moins un premier élément de renforcement en acier et/ou Inconel en combinaison avec au moins un élément de renforcement supplémentaire en un (ou plusieurs) métal (métaux) du groupe Hf, Nb, Ta, W, Re ou de l'alliage Ti 0,5 % en poids; Zr 0,07 % en poids; C 0,05 % en poids; le reste étant du Mo (TZM).

5. Supra-conducteur renforcé mécaniquement selon la revendication 1, caractérisé en ce qu'il possède au moins un premier élément de renforcement en un (ou plusieurs) alliage(s) du groupe Ti-V-Al, Cu-Zr, Cu-Si, Cu-Al$_2$O$_3$ ou Cu-Be, Cu-Be n'étant utilisé qu'en cas d'utilisation de cuivre ou de Cu-Sn ou Cu-Ga comme matériau de matrice en combinaison avec au moins un élément de renforcement supplémentaire en un (ou plusieurs) métal (métaux) du groupe Hf, Nb, Ta, W, Re ou de l'alliage Ti 0,5 % en poids; Zr 0,07 % en poids; C 0,05 % en poids, le reste étant du Mo (TZM).

6. Procédé de fabrication d'un supra-conducteur renforcé mécaniquement selon la revendication 1, dans lequel le matériau supra-conducteur dans le matériau de matrice est réuni avec le matériau pour le premier renforcement mécanique, d'un coefficient de dilatation thermique linéaire $\alpha$ supérieur à celui du matériau supra-conducteur, pour former un conducteur composé, avant de subir un traitement ultérieur, caractérisé en ce que le matériau pour le renforcement mécanique supplémentaire, d'un coefficient de dilatation thermique linéaire $\alpha$ inférieur à celui du matériau supra-conducterur est introduit de plus dans le conducteur composé, de sorte que l'effet de contraction supra-conducteur est du moins partiellement compensé.

7. Procédé selon la revendication 6, caracterisé en ce qu'on utilise du molybdène comme matériau de renforcement avec un $\alpha$ plus petit.

8. Procédé selon la revendication 6, caractérisé en ce qu'on utilise au moins une espèce du groupe Hf, Nb, Ta, W, Re, TZM (Ti à 0,5 % en poids; Zr à 0,07 % en poids; C à 0,05 % en poids; le reste étant du Mo) comme matériau de renforcement ayant un $\alpha$ plus petit.

9. Procédé selon la revendication 6, caractérisé en ce qu'on utilise au moins un élément de renforcement en Mo et au moins un élément de renforcement en un ou plusieurs matériaux du groupe Hf, Nb, Ta, W, Re, TZM comme matériau de renforcement ayant un $\alpha$ plus petit.

10. Procédé selon la revendication 6, caractérisé en ce qu'on utilise au moins une espèce du groupe Ti-V-Al, Cu-Zr, Cu-Si, Cu-Al$_2$O$_3$ ou Cu-Be comme matériau de renforcement ayant un $\alpha$ plus grand, Cu-Be n'étant utilisé qu'en cas d'utilisation de cuivre ou de Cu-Sn ou Cu-Ga comme matériau de matrice, et que l'on utilise du molybdène comme matériau de renforcement ayant un $\alpha$ plus petit.

11. Procédé selon la revendication 6, caractérisé en ce qu'on utilise au moins une espèce du groupe Ti-V-Al, Cu-Zr, Cu-Si, Cu-Al$_2$O$_3$ ou Cu-Be comme matériau de renforcement ayant un $\alpha$ plus grand, Cu-Be n'étant utilisé qu'en cas d'utilisation de cuivre ou de Cu-Sn ou Cu-Ga comme matériau de matrice, et que l'on utilise au moins une espèce du groupe Hf, Nb, Ta, W; RE, TZM comme matériau de renforcement ayant un $\alpha$ plus petit.

12. Procédé selon la revendication 6, caractérisé en ce qu'on utilise au moins un élément de renforcement en acier ou Inconel et/ou au moins un élément d'une ou de plusieurs matériau du groupe Ti-V-Al, Cu-Zr, Cu-Si, Cu-Al$_2$O$_3$ comme matériau de renforcement ayant un $\alpha$ plus grand, et au moins un élément de renforcement en un ou plusieurs matériaux du groupe Hf, Nb, Ta, W, Re, TZM comme matériau de renforcement ayant un $\alpha$ plus petit.

13. Procédé selon la revendication 6, caractérisé en ce que les matériaux de renforcement réunis en un compound avec le matériau supra-conducteur et la matrice qui l'entoure, sont introduits dans le supra-conducteur à une quantité qui correspond à un rapport situé entre 1 % et 50 % entre la somme des surfaces des sections transversales des matériaux de renforcement et la section transversale totale du supra-conducteur.

14. Procédé selon la revendication 6, caractérisé en ce que les matériaux de renforcement sont introduits dans le conducteur composé à une quantité qui correspond à un rapport situé entre 1 à 5 jusqu'à 5 à 1 entre la somme des sections transversales des matériaux ayant un $\alpha$ plus grand et la somme des sections transversales des matériaux ayant un $\alpha$ plus petit.

15. Procédé selon la revendication 6, caractérisé en ce que le matériau au $\alpha$ plus petit est introduit dans le conducteur composé à une distance du moins égale ou inférieure à la distance du matériau au $\alpha$ plus grand, par rapport à la ligne centrale du conducteur composé, ou que le matériau au $\alpha$ plus petit est introduit dans le conducteur composé à une distance du moins égale ou inférieure à la distance du matériau au $\alpha$ plus grand, par rapport à une ligne excentrique imaginaire dans le conducteur composé.

16. Procédé selon la revendication 6, caractérisé en ce que le matériau de renforcement est introduit dans le conducteur sous forme d'un ou de plusieurs éléments de renforcement composés, constitué chacun d'un matériau au $\alpha$ plus petit à l'intérieur et d'un matériau au $\alpha$ plus grand à l'extérieur.

17. Procédé selon l'une quelconque des revendications 12 à 16, caractérisé en ce que les deux matériaux de renforcement aux caractéristiques de dilatation thermique opposées sont introduits tels quels dans le conducteur composé, ou que les éléments de renforcement composés, constitués des deux derniers (fig. 1, fig. 2) sont introduits dans le conducteur composé symmétriquement par rapport au matériau supra-conducteur.

Fig. 1

Fig. 2

Fig. 3

Fig. 4

## Fig. 5

## Fig. 6

## Fig. 7

# Fig. 8

# Fig. 9

Fig. 10

Fig. 11

## Fig. 12